# EUROPEAN PATENT APPLICATION

(11) **EP 3 878 911 A1**
(43) Date of publication of application: **15.09.2021**
(21) Application number: 19881155.6
(22) Date of filing: 05.11.2019
(51) Int. Cl.: C08L 101/12, C09K 5/14, H05K 7/20

(54) **THERMALLY CONDUCTIVE COMPOSITION, THERMALLY CONDUCTIVE MEMBER, METHOD FOR PRODUCING THERMALLY CONDUCTIVE MEMBER, HEAT DISSIPATION STRUCTURE, HEAT GENERATING COMPOSITE MEMBER, AND HEAT DISSIPATING COMPOSITE MEMBER**

(30) Priority: 09.11.2018 JP 2018211300
(71) Applicant: Sekisui Polymatech Co., Ltd., Saitama-city, Saitama 338-0837 (JP)
(72) Inventor: ISHIDA, Keita, Saitama-city, Saitama 338-0837 (JP); KITADA, Gaku, Saitama-city, Saitama 338-0837 (JP)
(74) Representative: Ter Meer Steinmeister & Partner
(86) International application number: PCT/JP2019/043310
(87) International publication number: WO 2020/095902

(57) **Abstract**

There is provided a heat-conducting composition capable of forming thick films in good productivity. The heat-conducting composition contains a binder and a heat-conducting filler, wherein a first viscosity thereof is 50 to 300 Pa·s as measured at a rotating speed of 10 rpm at 25°C by using a rotational viscometer; and the ratio [second viscosity/first viscosity] of a second viscosity to the first viscosity is 3 to 8 where the second viscosity is a viscosity measured at a rotating speed of 1 rpm at 25°C by using the rotational viscometer.

## Description

### Technical Field

The present invention relates to a heat-conducting composition, a heat-conducting member, a method for producing a heat-conducting member, a heat-dissipating structure, a heating composite member, and a heat-dissipating composite member.

### Background Art

In order to dissipate heat generated by heat-generating elements of semiconductor devices, mechanical parts and the like, heat-dissipating elements such as heat sinks are used and to make heat conduction highly efficient, heat-conducting grease is applied between a heat-generating element and a heat-dissipating element in some cases.

With regard to the heat-conducting grease, since it is low in thermal conductivity as compared with a heat-generating element and heat-dissipating element (typically, made of a metal), a thinner heat-conducting grease is considered to be advantageous; for such a reason, in the case where the clearance between the heat-generating element and the heat-dissipating element is small, the heat-conducting grease has suitably been used.

In recent years, however, many of devices which generate heat come to be used and the total quantity of heat generated is likely to increase. Hence, it is desired to dissipate heat from everywhere, i.e., from multiple electronic devices or the entire of a substrate rather than a specific electronic device. Then, forms required for heat dissipation come to be diversified, including various heights of electronic devices being objects whose heat has to be dissipated, and occurrence of cases where a heat-dissipating element is assembled to a heat-generating element arranged obliquely or horizontally.

To meet such requirements, for example, Patent Literature 1 proposes a curing heat-conducting grease capable of smooth heat conduction from a heat-generating element to a heat-dissipating element, which is a curing heat-conducting grease containing a curable liquid polymer and more than one heat-conducting filler having predetermined particle diameters.

Further along with the diversification of forms required for heat dissipation, also with regard to a method of applying a heat-conducting grease, a method having high productivity is being demanded. Examples of such an application method include screen printing described in Patent Literature 1.

### Citation List

### Patent Literature

PTL1: JP 2011-151280 A

### Summary of Invention

### Technical Problem

The screen printing described in Patent Literature 1 has merits of being high in productivity, being capable of patterning in free shapes and being capable of imparting fine projections and depressions on the surface. Although screen printing using a heat-conducting grease is conventionally carried out, since the screen printing is unsuitable for thick film application, the printing is mainly on heat sinks of PCs and electronic apparatuses as objects, and has a purpose of forming thin films.

In recent years, however, also in markets for automobiles typically using EV batteries, the demand of applying heat-conducting grease by screen printing has grown. In such applications, thick film printing of heat-conducting grease is demanded. More specifically, in automobile applications, since the size of a unit containing a heat-generating element is relatively large and the design tolerance of the clearance between the heat-generating element and a heat-dissipating element is likely to become large, the formation of a rather thick film is required in order to absorb the tolerance. Further a rather thick and flexible heat-dissipating member is needed so that, even when vibrations are produced by mechanisms or driving of drive lines, no excessively large load is exerted on a heat-generating element and the like. Hence, the present situation is that conventional heat-conducting grease and screen printing using this cannot sufficiently meet the requirements in the above applications.

From the above, an object of the present invention is to provide a heat-conducting composition capable of forming a thick film in a good productivity.

### Solution to Problem

As a result of exhaustive studies, the present inventor has found that the above problem can be solved by paying attention to the viscosity and thixotropic ratio of heat-conducting compositions and controlling them in predetermined ranges, and thus completed the present invention. More specifically, the present invention is as follows.

[1] A heat-conducting composition comprising a binder and a heat-conducting filler, wherein a first viscosity thereof is 50 to 300 Pa·s as measured at a rotating speed of 10 rpm at 25°C by using a rotational viscometer; and the ratio [second viscosity/first viscosity] of a second viscosity to the first viscosity is 3 to 8 where the second viscosity is a viscosity measured at a rotating speed of 1 rpm at 25°C by using the rotational viscometer.
[2] The heat-conducting composition according to [1], wherein the average particle diameter of the heat-conducting filler is 10 to 80 µm and the content of particles thereof larger than 128 µm is 5% by volume or lower.
[3] The heat-conducting composition according to [1] or [2], wherein the binder is a thermosetting polymer; and the OO hardness as specified in ASTM D2240-05 of the heat-conducting composition after curing is 5 to 80.
[4] The heat-conducting composition according to any one of [1] to [3], wherein the heat-conducting composition comprises substantially no solvent.
[5] The heat-conducting composition according to any one of [1] to [4], wherein the heat-conducting composition is for screen printing.
[6] A heat-conducting member comprising a cured product made by curing a heat-conducting composition according to any one of [1] to [5], wherein the thickness of the cured product is 0.03 to 1 mm; and the OO hardness as specified in ASTM D2240-5 of the heat-conducting member is 5 to 80.
[7] The heat-conducting member according to [6], wherein the thickness of the cured product is 0.3 to 1 mm.
[8] The heat-conducting member according to [6] or [7], wherein the surface tack of the cured product is 0.05 N/10 mm or higher.
[9] The heat-conducting member according to any one of [6] to [8], wherein regular projections and depressions having a pitch of 0.1 to 2.5 mm are formed on at least one surface of the heat-conducting member.
[10] The heat-conducting member according to any one of [6] to [9], wherein the average height from the depressions to the projections is 10 to 500 µm.
[11] A method for producing a heat-conducting member, comprising an application step of applying a heat-conducting composition according to any one of [1] to [5] on an adherend through a screen printing plate, wherein the screen printing plate is prepared by patterning an emulsion in a thickness of 100 to 500 µm on a screen mesh woven of fibers of 20 to 250 µm in fiber diameter in 10 to 150 mesh.
[12] A heat-dissipating structure comprising a heat-dissipating element and a heat-conducting member disposed on the heat-dissipating element, wherein the heat-conducting member is a heat-conducting member according to any one of [6] to [10].
[13] The heat-dissipating structure according to [12], wherein a heat-generating element is disposed on the heat-conducting member.
[14] The heat-dissipating structure according to [12] or [13], wherein the heat-dissipating element is a heat sink.
[15] A heating composite member comprising a heat-generating element and a heat-conducting member according to any one of [6] to [10] disposed on the heat-generating element.
[16] A heat-dissipating composite member comprising a heat-dissipating element and a heat-conducting member according to any one of [6] to [10] disposed on the heat-dissipating element.

### Advantageous Effects of Invention

According to the present invention, there can be provided a heat-conducting composition capable of forming a thick film in a good productivity. For example, even in the case of screen printing, a relatively thick film can be formed. Further a flexible cured product can be formed directly on an adherend (heat-dissipating element or heat-generating element).

### Description of Embodiments

### [Heat-conducting composition]

Hereinafter, there will be described a heat-conducting composition according to an embodiment of the present invention.

The heat-conducting composition of the present invention comprises a heat-conducting composition binder and a heat-conducting filler, wherein a first viscosity thereof is 50 to 300 Pa·s as measured at a rotating speed of 10 rpm at 25°C by using a rotational viscometer. When the first viscosity is lower than 50 Pa·s, the shape retention of the heat-conducting composition patterned in a thick film state becomes lowered before and after curing thereof and the thermal conductivity becomes liable to decrease. With the first viscosity higher than 300 Pa·s, mesh clogging is liable to occur in screen printing, resulting in reducing the productivity.

The first viscosity is more preferably 150 to 300 Pa·s. The first viscosity of 150 to 300 Pa·s can provide high shape retention in particular and higher filling performance. Therefore, the heat conductivity can easily be increased. The first viscosity is more preferably 150 to 250 Pa·s. This is because the first viscosity of 150 to 250 Pa·s is especially preferable from the viewpoint of a balance between the printability and the shape retention.

In the heat-conducting composition of the present invention, the ratio [second viscosity/first viscosity] (referred to also as "thixotropic ratio") of a second viscosity to the first viscosity is 3 to 8 where the second viscosity is a viscosity measured at a rotating speed of 1 rpm at 25°C by using the rotational viscometer. With the [second viscosity/first viscosity] being lower than 3, the shape retention of the heat-conducting composition patterned in a thick film state becomes lowered before and after curing thereof, and in the case of trying to impart projections and depressions on the surface after the curing, the projections and depressions become difficult to form. With the [second viscosity/first viscosity] more than 8, mesh clogging is liable to occur in screen printing, resulting in reducing the productivity.

The [second viscosity/first viscosity] is more preferably 3.5 to 6. When that is in this range, there can be provided the heat-conducting composition holding printability in a rather high viscosity region and simultaneously being excellent particularly in the shape retention.

The first viscosity and the [second viscosity/first viscosity] can be controlled in a desired range by regulating the viscosity of the binder and the particle diameter of the heat-conducting filler, for example, regulating the ratio between larger particles and smaller particles, and the amount thereof to be added.

The [second viscosity/first viscosity] can also be regulated into a desired range by suitably mixing the heat-conducting composition with a reactive silicone oil described later.

### (Binder)

The binder includes thermosetting polymers and photocuring polymers, but is, in consideration of the productivity, preferably a thermosetting polymer. The thermosetting polymer is, from the viewpoint of the curing shrinkage, preferably an addition reaction-type polymer. When the heat-conducting composition is cured in the state of being interposed between a heat-generating element and a heat-dissipating element, in the case where the curing shrinkage is large, a gap is generated between the heat-generating element and the heat-dissipating element in some cases; but, in the case where the heat-conducting composition is the addition reaction-type polymer, since the curing shrinkage is small, the disadvantage of causing the gap hardly occurs.

The addition reaction-type polymer includes polyurethane, epoxy resins and poly-α-olefins, but a reaction curable silicone such as an organopolysiloxane is preferable in the point of the flexibility and the filling property of the heat-conducting filler.

The reaction-type silicone is preferably liquid at room temperature (25°C). The reaction-type silicone preferably contains a base resin and a curing agent being binder components, and the base resin is preferably a polyorganosiloxane having reactive groups capable of forming a crosslinking structure.

The reaction curable silicone is more preferably one containing an alkenyl group-containing organopolysiloxane (base resin) and a hydrogenorganopolysiloxane (curing agent).

The viscosity of the reaction curable silicone is preferably about 0.05 Pa·s to 2 Pa·s. The reaction curable silicone having a viscosity lower than 0.05 Pa·s is likely to have a low molecular weight and since the molecular weight is hardly increased even after it is cured, a cured product of the heat-conducting composition may be brittle. On the other hand, in the case of the silicone with a viscosity higher than 2 Pa·s, the viscosity of the heat-conducting composition is liable to increase, and therefore if the viscosity of the heat-conducting composition is brought into a desired range, the amount of the heat-conducting filler to be blended is smaller and the heat conductivity is difficult to increase.

From the viewpoint that a suitable flexibility is imparted to a cured product of the heat-conducting composition, it is preferable that the binder is a thermosetting polymer and the OO hardness of the heat-conducting composition after curing as specified in ASTM D2240-05 is 5 to 80. In a flexible cured product having an OO hardness of 80 or lower (hereinafter, referred to as OO80 or lower in some cases), an excessive stress is hardly generated even in the case where the clearance between a heat-dissipating element and a heat-generating element changes by vibrations and shocks. On the other hand, the hardness of OO5 or higher results in a lower risk that a cured product of the heat-conducting composition is broken since the cured product has some degree of strength.

The OO hardness is more preferably 5 to 55. In a flexible cured product having a hardness of OO55 or lower, even in the case where the cured product is brought into adhesion with a member having large projections and depressions, the adhesion can be achieved by a remarkably low stress. Such a remarkably flexible cured product easily deforms and the cured product formed into a sheet in advance easily deforms is thus difficult to handle singly, but by applying and curing the heat-conducting composition on a heat-dissipating element or a heat-generating element, the cured product can be easily handled.

The hardness can be measured specifically by a method described in Examples.

### (Silicone oil)

The heat-conducting composition of the present invention preferably contains a silicone oil. The silicone oil can be roughly classified into reactive silicone oil and non-reactive silicone oil.

The reactive silicone oil is a silicone oil having reactive functional groups and in a liquid state at room temperature (25°C). Inclusion of the reactive silicone oil can impart a suitable thixotropic property to the heat-conducting composition of the present invention.

The reactive functional group of the reactive silicone oil includes a hydroxy group, a carboxy group, an epoxy group and an amino group. Among these, from the viewpoint of the effect of imparting the thixotropic property, a hydroxy group is preferable.

As the reactive silicone oil, preferable is a reactive modified silicone oil having a main chain having siloxane bonds and reactive functional groups introduced to side chains bonded to the main chain or to terminals of the main chain. Examples of such a reactive modified silicone oil include carbinol-modified silicone oil, carboxy-modified silicone oil, epoxy-modified silicone oil and amino-modified silicone oil. Among these, preferable is at least one selected from the group consisting of carbinol-modified silicone oil, carboxy-modified silicone oil and epoxy-modified silicone oil; and more preferable is carbinol-modified silicone oil.

The reactive silicone oils can be used singly or in a combination of two or more.

The kinematic viscosity of the reactive silicone oil is, from the viewpoint of imparting a suitable thixotropic ratio to the heat-conducting composition of the present invention, preferably, at 25°C, 10 mm²/s or higher and 10,000 mm²/s or lower, more preferably 100 mm²/s or higher and 3,000 mm²/s or lower and still more preferably 100 mm²/s or higher and 1,000 mm²/s or lower.

The content of the reactive silicone oil is, with respect to 100 parts by mass of the reaction curable silicone, preferably in the range of 0.1 to 5 parts by mass, more preferably 0.2 to 4 parts by mass and still more preferably 0.5 to 3 parts by mass. When the content of the reactive silicone oil is 0.1 parts by mass or higher with respect to 100 parts by mass of the reaction curable silicone, the shape retention becomes good; and when 5 parts by mass or lower, a suitable thixotropic ratio can be imparted.

The non-reactive silicone oil is a silicone oil in a liquid state at room temperature (25°C) other than the reactive silicone oil. That is, the non-reactive silicone oil has no reactive functional group the reactive silicone oil has. Inclusion of the non-reactive silicone oil can impart the flexibility. Concurrent use of the reactive silicone oil and the non-reactive silicone oil provides a good shape retention of the heat-conducting composition after they are applied.

The non-reactive silicone oil includes straight silicone oil such as dimethyl silicone oil and phenyl methyl silicone oil, and besides, non-reactive modified silicone oil having non-reactive organic groups introduced to the main chain having siloxane bonds, side chains bonded to the main chain or terminals of the main chain. Examples of the non-reactive modified silicone oil include polyether-modified silicone oil, aralkyl-modified silicone oil, fluoroalkyl-modified silicone oil, long-chain alkyl-modified silicone oil, higher fatty acid ester-modified silicone oil, higher fatty acid amido-modified silicone oil and phenyl-modified silicone oil.

Among the above, as the non-reactive silicone oil, a straight silicone oil is preferable, and among the straight silicone oils, dimethyl silicone oil is more preferable.

The non-reactive silicone oils can be used singly or in a combination of two or more.

The kinematic viscosity of the non-reactive silicone oil is, from the viewpoint of imparting a good application property to the heat-conducting composition of the present invention, preferably, at 25°C, 10,000 mm²/s or higher and 1,000,000 mm²/s or lower and more preferably 100,000 mm²/s or higher and 500,000 mm²/s or lower.

The content of the non-reactive silicone oil is, with respect to 100 parts by mass of the reaction curable silicone, preferably in the range of 10 to 70 parts by mass, more preferably 20 to 70 parts by mass and still more preferably 35 to 60 parts by mass. When the content of the non-reactive silicone oil (C) is 10 parts by mass or higher with respect to 100 parts by mass of the reaction curable silicone, the shape retention becomes good; and when 70 parts by mass or lower, the application property becomes good.

The content of the non-reactive silicone oil is preferably higher than the content of the reactive silicone oil. The content ratio [non-reactive silicone oil/reactive silicone oil] of the non-reactive silicone oil to the reactive silicone oil is, in mass ratio, preferably in the range of 5 to 100, more preferably 10 to 80, still more preferably 15 to 50 and further still more preferably 15 to 30.

### (Heat-conducting filler)

In the heat-conducting filler, it is preferable that the average particle diameter is 10 to 80 µm, and the content of particles larger than 128 µm is 5% by volume or lower. The average particle diameter of 10 to 80 µm is likely to provide a higher thermal conductivity even in a thick film. The content of particles larger than 128 µm of 5% by volume or lower is likely to suppress mesh clogging in screen printing. When more than one heat-conducting filler is present, the above range should be satisfied as a whole.

The average particle diameter of the heat-conducting filler is more preferably 20 to 80 µm. This is because particularly the heat conductivity is likely to be higher.

Then the content of particles larger than 128 µm is more preferably 1% by volume or lower. Thereby, the mesh clogging in screen printing can be suppressed more.

As the average particle diameter of the heat-conducting filler can be used the median diameter D50 of the volume-average particle diameter in a particle size distribution measured by a laser diffraction scattering method (JIS R1629). Further the content of particles larger than 128 µm can also be determined from the particle size distribution.

Examples of the heat-conducting filler include spherical, flake or other powders of metals, metal oxides, metal nitrides, metal carbides, metal hydroxides or the like, and carbon fibers. The metals include aluminum, copper and nickel; the metal oxides include aluminum oxide, magnesium oxide, zinc oxide and quartz; the metal nitrides include boron nitride and aluminum nitride; the metal carbides include silicon carbide; and the metal hydroxides include aluminum hydroxide. The carbon fibers include pitch-based carbon fibers, PAN-based carbon fibers, fibers made by carbonizing resin fibers and fibers made by graphitizing resin fibers. Among these, in particular, in applications requiring the insulation, it is preferable to use powders of the metal oxides, metal nitrides, metal carbides or metal hydroxides.

The heat-conducting filler is preferably of a low-specific gravity material. More specifically, use of a material having a specific gravity of 4.0 or lower is preferable. Examples of the material having a specific gravity of 4.0 or lower include aluminum, aluminum oxide, magnesium oxide, quartz, boron nitride, aluminum nitride, silicon carbide, aluminum hydroxide and carbon fibers.

It is preferable that the heat-conducting filler contains at least two kinds of heat-conducting filler having different average particle diameters, or being composed of different materials, or having different shapes. As the heat-conducting filler having different average particle diameters, preferable is, for example, a heat-conducting filler containing, at least, a heat-conducting filler having an average particle diameter of 40 to 90 µm (large-particle diameter) and a heat-conducting filler having an average particle diameter of 30 µm or smaller (small-particle diameter). Thereby, it becomes easy for the closest-packing structure of the heat-conducting filler to be formed, whereby the heat conductivity can be improved more. From such a viewpoint, there may be used, for example, a heat-conducting filler containing two kinds of small-particle diameter heat-conducting filler (for example, a heat-conducting filler having an average particle diameter of 0.1 to 5 µm and a heat-conducting filler having an average particle diameter of 6 to 60 µm) and the large-particle diameter heat-conducting filler.

As the heat-conducting filler composed of different materials, preferable is, for example, a heat-conducting filler containing at least a combination of a heat-conducting filler of aluminum oxide and a heat-conducting filler of aluminum hydroxide. Use of aluminum hydroxide enables the specific gravity of the heat-conducting composition to be lowered and the separation of the heat-conducting filler to be suppressed. Further the flame retardancy can be enhanced. On the other hand, since aluminum oxide is easily available and relatively high in heat conductivity, it can effectively increase the thermal conductivity. Since aluminum hydroxide and aluminum oxide are both insulative, combinations thereof are suitable for applications requiring insulation.

As the heat-conducting filler having different shapes, preferable is, for example, a heat-conducting filler containing at least a combination of a spherical heat-conducting filler (for example, aluminum oxide) and a crushed heat-conducting filler (for example, aluminum hydroxide). Since the heat-conducting filler, when containing a spherical heat-conducting filler, is small in the specific surface area as compared with other shapes, even when there is increased the proportion of the large-particle diameter heat-conducting filler in the heat-conducting filler, it becomes difficult for the fluidity of the heat-conducting composition to be lowered. Then when the crushed heat-conducting filler is contained, addition of even a small amount thereof easily makes the thixotropic property to be enhanced and the shape retention to be enhanced. Here, "crushed" refers to a particle state of crushed particles having any angulated shapes, which state can be checked by an electron microscope or another microscope.

The content (packing fraction) of the heat-conducting filler in the heat-conducting composition is preferably 50 to 85% by volume and more preferably 60 to 80% by volume, if more than one heat-conducting filler are present, as a whole thereof. That is especially preferably 65 to 75% by volume, which makes it easy for both the heat conductivity and the shape retention to be simultaneously satisfied.

The heat-conducting composition as described above preferably contains substantially no solvent. Containing substantially no solvent makes shape retention and thick film formation easier. It is preferable also environmentally. Here, "containing substantially no solvent" refers to such a state that the weight loss after the heat-conducting composition is heated at 100°C for 2 hours is 1% by mass or lower. That is, the solid content concentration of the heat-conducting composition is preferably 99% by mass or higher. The weight loss can be measured, for example, by using a thermogravimetric analyzer (TGA).

The heat-conducting composition of the present invention is preferably for screen printing. A screen printing plate includes screen mesh plates and metal plates; and among these, screen mesh plates are more preferable. The screen mesh plates are inexpensive as compared with the metal plates, and are high in the degree of freedom of design of printing shapes and can also form so-called letter(s) containing an island portion. Further the screen mesh, since being composed of a resin material, has such a merit as of hardly marring adherends.

The heat-conducting composition of the present invention can form thick films and the use thereof in screen printing can achieve good productivity.

### <Forms of the heat-conducting composition>

The form of the heat-conducting composition of the present invention may be of a one-component type, or may be of a two-component type, which is used by mixing two components of a base resin and a curing agent and the like in the use time. The one-component type heat-conducting composition includes compositions containing a moisture-curable silicone as a reaction curable silicone.

As the two-component type heat-conducting composition, preferable are compositions containing the above-mentioned addition reaction curable silicone as a reaction curable silicone. Specifically, it is preferable that the two-component type heat-conducting composition is constituted of a first agent containing an addition reaction type organopolysiloxane as a base resin, such as an alkenyl group-containing organopolysiloxane, and a second agent containing a curing agent such as a hydrogenorganopolysiloxane.

In the case where the reaction curable silicone according to the present invention is of a two-component type, the heat-conducting filler and the like may be included in at least one of the first agent and the second agent. From the viewpoint of easily enhancing homogeneity of a mixture of the first agent and the second agent, the silicone oil is preferably contained in both of the first agent and the second agent in divided portions. From the similar viewpoint as in the above, the heat-conducting filler also is preferably contained in both of the first agent and the second agent in divided portions.

More specifically, it is more preferable that the two-component type heat-conducting composition is constituted of a first agent containing a base resin constituting a reaction curable silicone, a heat-conducting filler and preferably a silicone oil, and a second agent containing a curing agent constituting the reaction curable silicone, the heat-conducting filler, and preferably the silicone oil.

### [Heat-conducting member]

The heat-conducting member of the present invention is a heat-conducting member comprising a cured product made by curing the heat-conducting composition, wherein the thickness of the cured product is 0.03 to 1 mm. The cured product having a thickness of smaller than 0.03 mm is unsuitable for applications to automobiles and the like. On the other hand, the cured product having a thickness more than 1 mm, since the formation using a screen mesh plate is difficult, ends in becoming disadvantageous in the point of the productivity.

The thickness of the cured product is more preferably 0.3 to 1 mm. By bringing the thickness into 0.3 mm or larger, even in the case where the clearance between a heat-dissipating element and a heat-generating element changes by vibrations and shocks, a displacement enough to absorb the shocks and the like may occur, and therefore the cured product is especially suitable for automobile applications, which easily generate vibrations and shocks.

The OO hardness specified in ASTM D2240-05 of the heat-conducting member of the present invention is 5 to 80. By bringing the hardness of the heat-conducting member into OO80 or lower, even in the case where the clearance between a heat-dissipating element and a heat-generating element changes by vibrations and shocks, an excessive stress is hardly generated. On the other hand, the hardness of OO5 or higher provides the heat-conducting member with some degree of strength, and thus the risk of its breakage is lower.

The OO hardness is more preferably 5 to 55. Even when the heat-conducting member, in the case where being a flexible heat-conducting member having a hardness of OO55 or lower, is brought into adhesion with a member having large projections and depressions, the adhesion can be carried out in a remarkably low stress. Since such a remarkably flexible heat-conducting member is easily deformed, the heat-conducting member is preferably one previously formed integrally together with a heat-dissipating element and a heat-generating element.

The OO hardness specified in ASTM D2240-05 can be measured by a method described in Examples.

In the heat-conducting member of the present invention, the surface tack of the cured product is preferably 0.05 N/10 mm or higher and more preferably 0.1 to 2.0 N/10 mm. In the case of the tack of 0.05 N/10 mm or higher, when the heat-conducting member is disposed on an adherend, an adhesion force is generated in such a degree that no slipping of the adherend occurs, which can provide a heat-conducting member with good workability. The tack can be measured by a method described in Examples.

The heat-conducting member preferably has regular projections and depressions having a pitch of 0.1 to 2.5 mm formed on at least one surface thereof. By forming the projections and depressions in such a pitch, when the heat-conducting member is compression bonded to an adherend, occurrence of residual air bubbles can be prevented. The pitch is more preferably 0.15 to 0.7 mm. By regulating a pattern of a screen mesh, the above projections and depressions can be formed. The pitch is more preferably 0.2 to 0.5 mm.

Here, the regular projections and depressions refer to that, for example, in the case where the pitch is 1 mm, at least four projections are formed at intervals of 1 mm. Then, when an X direction and a y direction perpendicular to the x direction are defined in-plane, it is preferable that the projections and depressions are formed two-dimensionally in the x direction and the y direction. At this time, the pitches in the x direction and the y direction may be the same or different.

The height of the projections and depressions is preferably 10 to 500 µm. The height of the projections and depressions of 10 to 500 µm can prevent large air bubbles from remaining when the heat-conducting member is compression bonded to an adherend. The height of the projections and depressions is more preferably 50 to 250 µm. The height of the projections and depressions of 50 µm or larger can reduce a stress resulting from high compression of the heat-conducting member, and enhance the cushioning effect. The height thereof of 250 µm or smaller can allow nearly the whole of the heat-conducting member including the depressions to adhere to an adherend without excessive compression. The height of the projections and depressions can be measured by a method described in Examples.

The heat-conducting member of the present invention is suitably used, for example, in vehicle applications, electronic device applications, architecture applications and the like. The heat-conducting member is useful also particularly as a cushioning material for vehicular parts used by being applied on peripheries of automobile parts.

### [Method for producing the heat-conducting member]

A method for producing the heat-conducting member of the present invention comprises an application step of applying the heat-conducting composition of the present invention on an adherend through a specific screen printing plate.

As the screen printing plate, there is used one in which an emulsion is patterned in a thickness of 100 to 500 µm on a screen mesh (screen mesh plate) woven of fibers of 20 to 250 µm in fiber diameter in 10 to 150 mesh. The screen mesh with a 10 to 150 mesh woven of fibers of 20 to 250 µm in fiber diameter can provide a screen mesh plate which easily prints thick films. The patterning of the emulsion in a thickness of 100 to 1,000 µm further allows formation of thick films.

The fiber diameter is preferably 40 to 200 µm, and the mesh is preferably 40 to 120 mesh. The thickness of the emulsion is preferably 200 to 500 µm.

As a material of the screen plate, there is used a common material such as nylon, polyester or stainless steel. Also as the emulsion, a common one can be used; and as a method of forming an emulsion layer, a well-known method can be applied.

A screen printing machine includes a flatbed type, a cylindrical type and the like, but is not especially limited as long as being a screen printing machine capable of smoothly carrying out the printing operation and the screen mesh stripping operation; and a flatbed screen printing machine is usually used.

The heat-conducting member is produced by applying the heat-conducting composition on an adherend by the screen printing method and leaving it at room temperature or heating it, as necessary, the to form the cured product.

### [Heat-dissipating structure, heating composite member, heat-dissipating composite member]

The heat-dissipating structure of the present invention comprises a heat-dissipating element and a heat-conducting member disposed on the heat-dissipating element, wherein the heat-conducting member is the heat-conducting member of the present invention. It is preferable that on the heat-conducting member, a heat-generating element is disposed.

Further, the present invention is a heating composite member having the heat-conducting member of the present invention disposed on the surface of a heat-generating element. Further, the present invention is a heat-dissipating composite member having the heat-conducting member of the present invention disposed on the surface of a heat-dissipating element.

As the heat-dissipating element, preferable is one utilizing a material having a thermal conductivity of 20 W/mK or higher, for example, a material of a metal such as stainless steel, aluminum or copper, graphite, diamond, aluminum nitride, boron nitride, silicon nitride, silicon carbide or aluminum oxide. The heat-dissipating element using such a material includes heat sinks, housings and pipelines for heat dissipation; and among these, heat sinks are preferable.

The heat-generating element includes automobile parts such as EV batteries; usual power sources; electronic devices such as power transistors for power sources, power modules, thermistors, thermocouples and temperature sensors; and heat-generating electronic parts such as integrated circuit devices such as LSI and CPU; and among these, being automobile parts such as EV batteries is preferable.

### Examples

Hereinafter, the present invention will be described in more details by way of Examples, but the present invention is not any more limited to these Examples.

In the present Examples, a heat-conducting composition obtained in each Example was evaluated by the following methods.

### [Viscosity]

The viscosity (Pa·s) at 25°C right after preparation of a heat-conducting composition (right after mixing of a first agent and a second agent described later) was measured by using a B-type viscometer (rotational viscometer, manufactured by Brookfield Engineering Laboratories, Inc., DV-E) under a set condition of a rotating speed of a spindle (SC4-14) of 1 rpm or 10 rpm. The value of the viscosity was read as a value after the spindle was rotated for 2 min at each rotating speed. Here, the value at a rotating speed of 10 rpm was taken as a first viscosity; and the viscosity at 1 rpm was taken as a second viscosity.

### [Thixotropic ratio]

From the values of the first viscosity and the second viscosity measured in the above method, the ratio [second viscosity/first viscosity] of the second viscosity to the first viscosity was calculated as a thixotropic ratio.

### [Thermal conductivity]

A heat-conducting composition of each Example was screen printed on a release film (fluorine film) by using a screen printing plate in which an emulsion in a thickness of 500 µm was patterned to form a rectangular printing shape of 40 × 40 mm on a mesh (80 mesh, opening: 238 µm) woven of polyester fibers of 80 µm in fiber diameter. Then, the resultant was left at room temperature (25°C) for 24 hours to be cured to thereby fabricate a test piece for measuring thermal conductivity composed of a cured product having a rectangular shape of 40 × 40 mm of 0.7 mm in thickness. Then, for the each test piece, the thermal conductivity was measured by a method according to ASTM D5470-06.

### [Hardness after curing]

For a heat-conducting composition of each Example, there was fabricated a test piece for measuring hardness composed of a cured product of 40 × 40 mm and of 6 mm in thickness by using a molding die. Then, for the each test piece, the hardness was measured by using a type-OO durometer and by a method according to ASTM D2240-05.

### [Printability (degree of generation of mesh clogging)]

A heat-conducting composition of each Example was printed on an adherend (a polyethylene terephthalate film of 100 µm in thickness) by using a screen printing plate in which a rectangular printing shape of 5 × 8 mm was patterned with the same emulsion in a thickness of 500 µm as in the fabrication of a test piece for measuring thermal conductivity on a screen mesh (wire diameter: 80 µm, 80 mesh) having the same specification as in the fabrication. Then, the resultant was left at room temperature (25°C) for 24 hours to be cured to thereby fabricate a heat-conducting member in which a cured product of about 0.7 mm in thickness was formed. The printing state after the printing and the screen mesh were evaluated according to the following criteria.
"A": Printing could be carried out and almost no heat-conducting composition remained on the meshes of the screen printing plate after the printing.
"B": Though printing could be carried out, when the meshes of the screen printing plate after the printing were visually checked, the composition remained in a small amount on mesh intersections and the like.
"C": No whole printing pattern could be printed on the adherend.

### [Solid content]

For a heat-conducting composition, the weight loss of 120°C/2 hours was measured by using a thermogravimetric analyzer ("DTG60" manufactured by Shimadzu Corp.), and "the proportion (W1/ W0) of the weight (W1) after the measurement to the weight (W0) before the measurement" was taken as the proportion of the solid content.

### [Height and pitch of surface projections and depressions]

The height of projections and depressions was estimated by observing a cross section of a sample fabricated in "Printability (degree of generation of mesh clogging)". Specifically, five projections were sampled and an average height of projections and depressions was determined. Further the pitch between projections and depressions was measured.

### [Tack strength]

The following peel test (180° peel test) was carried out and the tack strength as the peel strength was evaluated.

### <Fabrication of test samples>

An aluminum foil of 11 µm in thickness and a polyethylene terephthalate film with a pressure-sensitive adhesive agent (polyethylene terephthalate layer: 75 µm, pressure-sensitive adhesive layer: 5 µm, hereinafter, referred to as PET film) were laminated through the pressure-sensitive adhesive agent layer to obtain an aluminum foil/PET film laminate. The laminate was cut out into 250 mm in length and 10 mm in width to make an adherend test piece. Then, a heat-conducting composition of each Example was applied by using a doctor blade on one end side of a stainless steel (SUS304) plate (SUS plate) of 180 mm in length, 100 mm in width and 10 mm in thickness so that a coated film measured 100 mm, 60 mm and 2 mm in length, width and thickness, respectively. Then, the aluminum foil surface of the adherend test piece was laminated on the coated film of the heat-conducting composition, and left at room temperature (25°C) for 24 hours to cure the coated film into a cured product to thereby fabricate a test sample. One end of the adherend test piece was protruded in a predetermined length from the SUS plate so that the adherend test piece could be chucked by a test apparatus.

### [Measurement method]

The test sample was set on the test apparatus (Strograph VE50 (manufactured by Toyo Seiki Seisaku-sho Ltd.). Specifically, first, the one end of the adherend test piece was attached to an upper chuck of the apparatus so that the peeling mode became 180° peel. The chuck was pulled upward at a test speed of 300 mm/min to carry out a 180° peel test.

From the tensile stress obtained, an average stress in a portion where the stress was stable (in the peel distance of 100 mm) was calculated. Three test samples were measured.

### [Shape retention: dimensional change rate in plane]

By using a sample (patterned in a dimension (area S0) of 5 mm × 8 mm) fabricated in [Printability (degree of generation of mesh clogging)], the area of a printed heat-conducting composition after curing (S1) was estimated, and the expansion ratio (S1/S0) in area was calculated.

The case where the expansion ratio in area was lower than 10% was taken as "A"; 10% or higher and lower than 30%, as "B"; and 30% or higher, as "C".

### Example 1 (Preparation and evaluation of a heat-conducting composition)

A base resin constituting an addition reaction curable silicone and a dimethyl silicone oil being a non-reactive silicone oil were mixed to thereby prepare a first agent. On the other hand, a curing agent constituting the addition reaction curable silicone and a heat-conducting filler were mixed to thereby prepare a second agent. The amount (parts by mass) of each component to be blended in the total amount of the first agent and the second agent is as shown in Table 1.

The first agent and second agent obtained were mixed to thereby prepare a heat-conducting composition, and the various evaluations were carried out by the above methods. The results are shown in Table 1.

### Examples 2 to 7, Comparative Examples 1 to 4

Heat-conducting compositions were prepared by the same method as in Example 1, except for altering the formulations of the heat-conducting compositions to those shown in Table 1. The results are shown in Table 1.

The components shown in Table 1 were as follows. Here, any of the blend amounts shown in Table 1 was an active component amount.
- Base resin of the addition reaction curable silicone: viscosity of 400 mPa·s (25°C)
- Curing agent of the addition reaction curable silicone: viscosity of 300 mPa·s (25°C)
- Dimethyl silicone oil: viscosity of 100 mPa·s (25°C)
- Aluminum hydroxide A: crushed type, average particle diameter of 1 µm
- Aluminum hydroxide B: crushed type, average particle diameter of 10 µm
- Aluminum hydroxide C: crushed type, average particle diameter of 50 µm
- Aluminum oxide A: spherical type, average particle diameter of 0.5 µm
- Aluminum oxide B: spherical type, average particle diameter of 3 µm
- Aluminum oxide C: spherical type, average particle diameter of 20 µm
- Aluminum oxide D: spherical type, average particle diameter of 45 µm
- Aluminum oxide E: spherical type, average particle diameter of 70 µm

### [Table 1]

**Table 1**

| | | Example 1 | Example 2 | Example 3 | Example 4 | Example 5 | Example 6 | Example 7 | Comparative Example 1 | Comparative Example 2 | Comparative Example 3 | Comparative Example 4 |
|---|---|---|---|---|---|---|---|---|---|---|---|---|
| Addition reaction curable silicone | | 70 | 100 | 100 | 100 | 100 | 100 | 100 | 100 | 100 | 80 | 100 |
| Dimethyl silicone oil | | 30 | | | | | | | | | 20 | |
| Aluminum hydroxide A | | | 150 | 140 | | | | 140 | 20 | | | |
| Aluminum hydroxide B | | 100 | 150 | | 80 | 90 | | | | | | |
| Aluminum hydroxide C | | | 300 | | | | | | | 140 | | |
| Aluminum oxide A | | 80 | | | 64 | 80 | 50 | | | | 150 | |
| Aluminum oxide B | | 200 | | 200 | 160 | 210 | 300 | 200 | | 200 | 470 | 300 |
| Aluminum oxide C | | 300 | | | 300 | 300 | | 50 | 100 | | | |
| Aluminum oxide D | | | | | | | 400 | | 200 | | | |
| Aluminum oxide E | | | | 600 | | | | 500 | | 100 | 950 | 600 |
| Packing fraction of heat-conducting filler (% by volume) | | 65 | 71 | 72 | 62 | 65 | 65 | 71 | 46 | 57 | 80 | 69 |
| Average particle diameter (µm) | | 11 | 28 | 42 | 12 | 11 | 25 | 38 | 33 | 36 | 43 | 48 |
| Proportion of particles of 128 µm or larger (% by volume) | | 0.0% | 2.0% | 0.9% | 0.0% | 0.0% | 0.0% | 0.8% | 0.0% | 2.0% | 1.0% | 1.1% |
| Viscosity (Pa·s | Second viscosity (1 rpm) | 530 | 1000 | 1000 | 240 | 770 | 380 | 980 | 7 | 60 | 1500 | 460 |
| | First viscosity (10 rpm) | 104 | 240 | 250 | 52 | 128 | 120 | 200 | 3 | 15 | 400 | 220 |
| [Second viscosity/first viscosity] | | 5.1 | 4.2 | 4.0 | 4.6 | 6.0 | 3.2 | 4.9 | 2.3 | 4.0 | 3.8 | 2.1 |
| Thermal conductivity (W/m·K) | | 2.2 | 2.1 | 3.1 | 1.9 | 2.3 | 2.5 | 2.9 | 1 | 1.4 | 4.5 | 2.6 |
| Hardness after curing (OO hardness) | | 5 | 50 | 55 | 10 | 70 | 30 | 80 | 20 | 20 | unmeasurable | 50 |
| Shape retention | | B | A | A | B | B | B | A | C | C | unmeasurable | C |
| Printability (degree of generation of mesh clogging) | | A | B | B | A | B | B | B | B | B | C | B |
| Solid content (%) | | 99% or higher | 99% or higher | 99% or higher | 99% or higher | 99% or higher | 99% or higher | 99% or higher | 99% or higher | 99% or higher | 99% or higher | 99% or higher |
| Average height of projections and depressions on surface (mm) | | 0.5 | 0.4 | 0.4 | 0.1 | 0.5 | 0.2 | 0.5 | 0.01 | 0.01 | unmeasurable | 0.03 |
| Pitch of surface (mm) | | 0.3 | 0.3 | 0.3 | 0.3 | 0.3 | 0.3 | 0.3 | 0.3 | 0.3 | unmeasurable | 0.3 |
| Tack strength (N/10 mm) | | 0.4 | 0.3 | 0.6 | 0.3 | 0.3 | 0.4 | 0.5 | 0.3 | 0.4 | 0.4 | 0.3 |

As is clear from the results of Table 1, the heat-conducting composition of the present invention can form thick films well by screen printing, and the hardness of the cured product of the composition is low and good.

### Industrial Applicability

The heat-conducting member using the heat-conducting composition of the present invention is suitably used, for example, as waterproof and vibration-proof materials in vehicle applications, electronic device applications and architecture applications.

## Claims

1. A heat-conducting composition comprising a binder and a heat-conducting filler,
wherein a first viscosity of the heat-conducting composition is 50 to 300 Pa·s as measured at a rotating speed of 10 rpm at 25°C by using a rotational viscometer; and a ratio [second viscosity/first viscosity] of a second viscosity to the first viscosity is 3 to 8 where the second viscosity is a viscosity of the heat-conducting composition as measured at a rotating speed of 1 rpm at 25°C by using the rotational viscometer.

2. The heat-conducting composition according to claim 1, wherein an average particle diameter of the heat-conducting filler is 10 to 80 µm and a content of particles thereof larger than 128 µm is 5% by volume or lower.

3. The heat-conducting composition according to claim 1 or 2, wherein the binder is a thermosetting polymer; and
an OO hardness specified in ASTM D2240-05 of the heat-conducting composition after curing is 5 to 80.

4. The heat-conducting composition according to any one of claims 1 to 3, wherein the heat-conducting composition comprises substantially no solvent.

5. The heat-conducting composition according to any one of claims 1 to 4, wherein the heat-conducting composition is for screen printing.

6. A heat-conducting member comprising a cured product made by curing a heat-conducting composition according to any one of claims 1 to 5,
wherein a thickness of the cured product is 0.03 to 1 mm; and
an OO hardness specified in ASTM D2240-05 of the heat-conducting member is 5 to 80.

7. The heat-conducting member according to claim 6, wherein a thickness of the cured product is 0.3 to 1 mm.

8. The heat-conducting member according to claim 6 or 7, wherein a surface tack of the cured product is 0.05 N/10 mm or higher.

9. The heat-conducting member according to any one of claims 6 to 8, wherein regular projections and depressions having a pitch of 0.1 to 2.5 mm are formed on at least one surface of the heat-conducting member.

10. The heat-conducting member according to any one of claims 6 to 9, wherein an average height from the depressions to the projections is 10 to 500 µm.

11. A method for producing a heat-conducting member, comprising an application step of applying a heat-conducting composition according to any one of claims 1 to 5 on an adherend through a screen printing plate, wherein the screen printing plate is prepared by patterning an emulsion in a thickness of 100 to 500 µm on a screen mesh woven of fibers of 20 to 250 µm in fiber diameter in 10 to 150 mesh.

12. A heat-dissipating structure comprising a heat-dissipating element and a heat-conducting member disposed on the heat-dissipating element,
wherein the heat-conducting member is a heat-conducting member according to any one of claims 6 to 10.

13. The heat-dissipating structure according to claim 12, wherein a heat-generating element is disposed on the heat-conducting member.

14. The heat-dissipating structure according to claim 12 or 13, wherein the heat-dissipating element is a heat sink.

15. A heating composite member comprising a heat-generating element and a heat-conducting member according to any one of claims 6 to 10 disposed on the heat-generating element.

16. A heat-dissipating composite member comprising a heat-dissipating element and a heat-conducting member according to any one of claims 6 to 10 disposed on the heat-dissipating element.
